# EUROPÄISCHE PATENTANMELDUNG

(11) **EP 4 478 844 A1**
(43) Veröffentlichungstag der Anmeldung: **18.12.2024**
(21) Anmeldenummer: 23179285.4
(22) Anmeldetag: 14.06.2023
(51) Int. Cl.: H05K 3/34, B23K 1/008, B23K 1/015, B23K 3/08, C23C 16/00, F28D 9/00, F28D 21/00, H01L 21/00, F28D 7/10, H01L 21/02

(54) **VERFAHREN UND VORRICHTUNG ZUR ENERGIEEINSPARUNG IN ELEKTRONISCHEN FERTIGUNGSPROZESSEN MITTELS WÄRME- UND MEDIENRÜCKGEWINNUNG**

(71) Anmelder: Siemens Aktiengesellschaft, 80333 München (DE)
(72) Erfinder: Jeske, Nora, 10555 Berlin (DE); Müller, Bernd, 16259 Falkenberg (DE); Raab, Oliver, 94496 Ortenburg (DE); Sommerfeld, Dennis, 12347 Berlin (DE); Wittreich, Ulrich, 16727 Velten (DE)
(74) Vertreter: Siemens Patent Attorneys

(57) **Zusammenfassung**

Die Erfindung betrifft eine Vorrichtung (20) und ein Verfahren zur Energieeinsparung in Elektronik-Fertigungsanlagen beziehungsweise Elektronik-Fertigungsprozessen, insbesondere für mikroelektronische Bauteile. Dabei wird eine Wärmerückgewinnung, z.B. aus der Abluft und aus der Abwärme von Gehäuseteilen sowie eine daran gekoppelte Medienrückgewinnung vorgeschlagen, insbesondere eine Prozessgas- und/oder Inertgasrückgewinnung.

## Beschreibung

Die Erfindung betrifft ein Verfahren zur Energieeinsparung in Fertigungsprozessen sowie eine Vorrichtung zur Energieeinsparung in entsprechenden Fertigungsanlagen, insbesondere elektronischen Fertigungsanlagen.

### Stand der Technik:

In Elektronik-Fertigungsprozessen ist häufig eine inerte Atmosphäre, beispielsweise eine Stickstoffatmosphäre (N2) erforderlich. Da dieses Prozessgas kontinuierlich mit Ausgasungsprodukten von Verbindungspartnern kontaminiert wird, ist eine permanente Erneuerung der Inertgasatmosphäre notwendig. Dazu wird das Inertgas bevorzugt über eine Absaugung aus dem Elektronik-Fertigungsprozess entfernt. In der Regel werden diese Prozessabgase bisher direkt an die Umwelt abgeführt. In ersten Ansätzen werden Teile des Prozessgases auch gereinigt und dem Prozess wieder zur Verfügung gestellt. Dies geschieht insbesondere beim Kondensatmanagement in Reflow-Lötanlagen. Je nach Elektronikfertigungsprozess wird auch eine Absaugung der Atmosphäre zwischen Prozesskammern und Gehäuse für thermische Prozesse vorgenommen. Dies geschieht teilweise auch zur Reduzierung der Gehäuseaußentemperatur.

Unter elektronischem Fertigungsprozess sind beispielsweise Prozesse wie Löten, Sintern, Trocknen etc. zu verstehen, wobei der wichtige Anwendungsbereich des hier vorgeschlagenen Prozesses bei den thermischen Prozessen der Elektronikfertigung liegt. Insbesondere beim Löten bzw. beim Reflow-Löten kommt es vermehrt zu Ausgasungsprodukten der Verbindungspartner, die aus dem Prozessgas abgetrennt werden müssen. Bei aktuellen modernen Reflow-Lötanlagen wird daher ein Teil des Prozessgases abgesaugt, beispielsweise über lokale Kondensatabscheider gereinigt, und dem Prozessraum wieder zugeführt. Dabei kühlt das Prozessgas auch merklich ab. Bei der Nutzung von Kondensatabscheidern müssen diese außerdem in Intervallen gewaschen oder über Pyrolyse gereinigt werden.

Ausgehend vom zuvor beschriebenen Stand der Technik liegt der Erfindung die Aufgabe zugrunde, die Energieverluste in Elektronikfertigungen, welche beispielsweise durch Abwärme und/oder Abgase gebildet werden, zu minimieren.

Diese Aufgabe wird durch die Merkmale des Patentanspruchs 1 gelöst. Des Weiteren wird diese Aufgabe durch die Merkmale des Patentanspruchs 12 gelöst. Vorteilhafte Ausgestaltungen der Erfindung sind Gegenstand der Unteransprüche.

Das erfindungsgemäße Verfahren zur Energieeinsparung in elektronischen Fertigungsprozessen, insbesondere mikroelektronischen Fertigungsprozessen, umfasst eine Wärmerückgewinnung und/oder eine Medienrückgewinnung. Besonders vorteilhaft umfasst das Verfahren eine Wärmerückgewinnung, die mit einer Medienrückgewinnung gekoppelt ist. Dies hat den Vorteil, dass weniger Energie in Form von beispielsweise Wärme dem Fertigungsprozess verloren geht. Gleichzeitig wird auch auf einen Prozessgasrücklauf geachtet, welcher gleichermaßen für eine verringerte Wärmeabgabe an die Umwelt aber auch einen verringerten Prozessgasverbrauch gewährleistet.

Besonders vorteilhaft dabei ist die gekoppelte Wärme- und Medienrückgewinnung, welche gleichermaßen Abwärme und Abluft in den Fertigungsprozess zurückführt. Insbesondere wird dabei die Abwärme der Abluft noch zurückgeführt bzw. zurückgehalten.

Zweckdienlicherweise umfasst das erfindungsgemäße Verfahren demnach einen Fertigungsprozess mit zumindest einem thermischen Prozess, dessen Abwärme mittels eines Wärmetauschprozesses zumindest teilweise rückführbar ist. Für eine effiziente thermische Rückführung aus einem Wärmetauschprozess liegt die Temperatur der Abwärme mindestens 5K über der Umgebungstemperatur im Raum der Anlage, bevorzugt >10K.

Besonders vorteilhaft ist die Wärmerückführung mittels eines Wärmetauschprozesses auf Fertigungsprozesse anwendbar, deren thermischer Prozess ein Hochtemperaturprozess ist. Bei Hochtemperatur-Prozessen handelt es sich um Prozesse mit beheiztem Prozessraum, in welchem die Temperatur mindestens 50K höher ist als die Umgebungstemperatur. Die Temperaturuntergrenze liegt bei ca. 70°C, insbesondere 80°C. Für eine besonders effiziente thermische Rückführung aus einem Wärmetauschprozess sollte eine Abwärmetemperatur von mindestens 40°C oder 20K über Umgebungstemperatur vorliegen.

Ein Beispiel für einen derartigen geeigneten thermischen Prozess in einem elektronischen Fertigungsverfahren ist die chemische Gasphasenabscheidung (Chemical Vapor Deposition - CVD). Dabei handelt es sich um ein Beschichtungsverfahren, beispielsweise ein Dünnschicht-Beschichtungsverfahren, welches bevorzugt im Bereich der Herstellung von mikroelektronischen Bauteilen eingesetzt wird. Im Gegensatz zu physikalischen Beschichtungsverfahren erfolgt bei der chemischen Gasphasenabscheidung eine chemische Reaktion aus der Gasphase an einem erhitzten Substrat auf einer Oberfläche. In diesem angewandten Fall bewirkt das erfindungsgemäße Verfahren den Vorteil, eine geringere Temperatur dem Reaktionssystem zuführen zu müssen, da durch die Wärmerückgewinnung ein Teil der Abwärme im System gehalten werden kann. Auch gereinigtes Abgas kann dem Gasphasenabscheidungsprozess wieder zugeführt werden.

In einer weiteren vorteilhaften Ausführungsform der Erfindung weist das Verfahren eine Wärmerückgewinnung auf, welche zumindest teilweise aus einem Wärmetauschprozess aus heißem Prozessabgas erfolgt. Alternativ umfasst eine Ausführungsform des erfindungsgemäßen Verfahrens einen Wärmetauschprozess aus heißen Gehäuseteilen. Dies hat den Vorteil, dass nicht nur weniger Wärme an die Umgebung verlustmäßig abgegeben wird, sondern gegebenenfalls auch aktive Kühlungsmaßnahmen vermieden werden können.

Besonders vorteilhaft sind bei der Wärmerückgewinnung Wärmetauschprozesse umfasst, welche bei Temperaturen zwischen 20°C und 80°C, insbesondere zwischen 20°C und 60°C, besonders vorteilhaft zwischen 20°C und 40°C erfolgen.

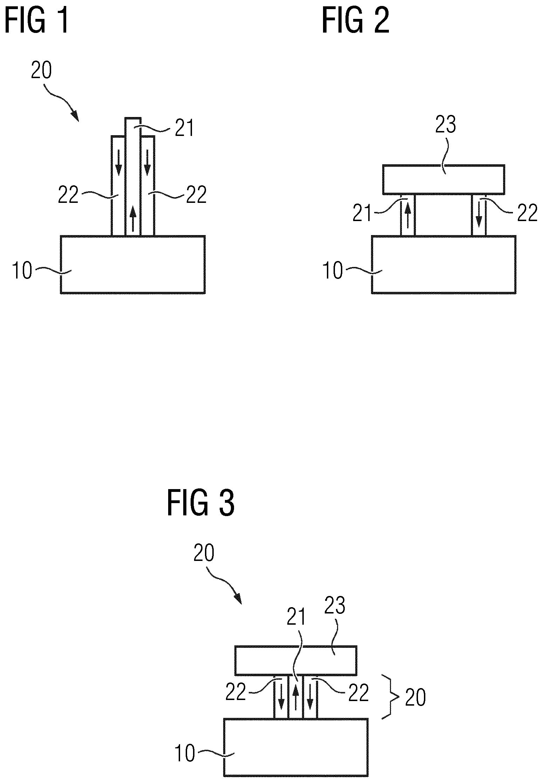

Besonders zweckdienlich ist in dem erfindungsgemäßen Verfahren eine Medienrückgewinnung umfasst, welche als Prozessgasrückgewinnung ausgestaltet ist. Die Prozessgasrückgewinnung kann dabei beispielsweise eine Prozessgasreinigung oder eine Prozessgasfiltration, bevorzugt beides umfassen. Beispielsweise erfolgt die Prozessgasrückgewinnung über ein Kondensatmanagement in einem geschlossenen Kreislauf. Unter Kondensatmanagement ist ein entsprechend vorgegebener Parameter geregelter Absaug- und Reinigungsprozess für das Prozessgas zu verstehen. Geschlossener Kreislauf bedeutet die Entnahme von Prozessgas aus dem Prozessraum, Reinigung und vollständige Wiederzuführung direkt in den Prozessraum, siehe auch Figur 3. Von einem geschlossenen Kreislauf wird beispielsweise noch gesprochen, wenn ein Mindestmaß an Prozessgas im Prozesskreislauf gehalten wird, insbesondere mehr als 80%.

Die erfindungsgemäße Vorrichtung zur Energieeinsparung in elektronischen Fertigungsanlagen, insbesondere mikroelektronischen Fertigungsanlagen, umfasst wenigstens eine Wärmerückgewinnungseinheit und/oder wenigstens eine Medienrückgewinnungseinheit. Bevorzugt umfasst die Vorrichtung eine Wärmerückgewinnungseinheit, welche mit einer Medienrückgewinnungseinheit gekoppelt ist. Unter der Kopplung von Wärmerückgewinnungseinheit und Medienrückgewinnungseinheit ist beispielsweise eine Wärmerückgewinnung aus heißem Abgas gemeint, d. h. dass Wärme aus einem Verbrauchsmedium zurückgewonnen wird und dieses gleichzeitig in einem Kreislauf, insbesondere einem Reinigungs- oder Filtrationskreislauf, zurückgeführt wird. Auch die Rückführung von noch warmem Prozessgas ist eine Form der gekoppelten Wärme- und Medienrückführung. Alternativ kann gereinigtes filtriertes und dabei abgekühltes Prozessgas über Wärmetauscherverfahren wieder vorgewärmt in den Prozess zurückgeführt werden, was auch einer gekoppelten Wärmemedienrückgewinnung im Sinne der vorgeschlagenen Vorrichtung entspräche.

In einer besonders vorteilhaften Ausführungsform der Vorrichtung ist eine Wärmerückgewinnungseinheit umfasst, welche einen Wärmetauscher, insbesondere ein Wärmetauscherrohr und/oder einen Plattenwärmetauscher aufweist. Mindestens ein Wärmetauscherrohr ist bevorzugt mehrwanding, insbesondere doppelwandig ausgeführt und insbesondere für eine gleichzeitige Medien- und Prozessgasrückführung geeignet. Rohre werden bevorzugt in der Peripherie der Anlage eingesetzt. Plattenwärmetauscher können bevorzugt mehrwandig, insbesondere doppelwandig ausgeführt sein und zur Effiziensteigerung insbesondere an eine Gehäusegeometrie angepasst, sodass besonders heiße Gehäuseteile vorteilhaft entwärmt und dessen Wärme rückgeführt werden kann.

In einer weiteren vorteilhaften Ausführungsform der Erfindung umfasst die Vorrichtung eine Medienrückgewinnungseinheit, welche eine Schnellabsaugung aufweist. Die Schnellabsaugung für Prozessgase kann dabei mit einer optimierten Lüfterleistung und/oder einer optimierten Lüfterfrequenz ausgestattet sein, sodass der Volumenstrom des Prozessgases in einem thermisch und reinigungs- bzw. filtrationsbedingt optimierten Kreislauf geführt werden kann.

Reflow-Öfen werden in unterschiedlichen Temperaturniveaus betrieben (Produktcluster-spezifische Temperaturprofile). Wenn aufgrund einer Produktumstellung eine Änderung des Temperaturprofils auf eine kältere Temperatur notwendig ist, dauert die Abkühlung aufgrund der relativ guten Isolation der Öfen meist sehr lange. Aufheizzeiten sind generell sehr viel geringer als Abkühlzeiten. In dieser Zeit, kann nicht produziert werden. Aus diesem Grund werden bisher sogenannte Schnellabsaugungen eingesetzt, die bei Produktumstellung das heiße Gas, bevorzugt an einer mittig gelegenen zentralen Position, absaugen und direkt in die zentrale Abluft abführen. Dieser Vorgang wird noch beschleunig, indem die Lüfterfrequenzen der jeweiligen Zonen erhöht werden und so eine stärkere Luftumwälzung im gesamten Ofen erfolgt. Zusätzlich kann die Transportweite maximal gestellt werden und insbesondere das Ansaugen kalter Luft von außen erfolgen.

Die vorteilhafte Ausführungsform der Erfindung mit der Medienrückgewinnungseinheit bewirkt nun, dass die Maßnahme der Schnellabsaugung, die dazu dient, den Ofen schnell auf die neue erforderliche Temperatur herunterzukühlen, keine Energie in Form von Wärme und Prozessgas vernichtet. Vielmehr wird diese Wärme genutzt, um kalte Prozessgase, insbesondere auch von Nachbarprozessen, in der Ansaugung zu erwärmen (Wärmerückgewinnung) und darüber das abgesaugte heiße Gas (inkl. Prozessgas N₂) so weit abzukühlen, dass es selbst dem eigentlichen Prozessraum wieder zugeführt werden kann (Kreislauf). Dabei könnte auch eine Prozessgasreinigung eingesetzt werden, um das Gas gekühlt und gereinigt zurückzuführen. Ein weiterer Vorteil dabei ist die Rückführung von bereits vorgewärmtem Prozessgas, welches die notwendige Prozessenergie reduziert, die zugeführt werden muss.

Es wird also eine vorteilhafte Vorrichtung und ein Verfahren zur Energieeinsparung in Elektronik-Fertigungsanlagen beziehungsweise Elektronik-Fertigungsprozessen vorgeschlagen, insbesondere für mikroelektronische Bauteile. Dabei wird eine Wärmerückgewinnung, z.B. aus der Abluft und aus der Abwärme von Gehäuseteilen sowie eine daran gekoppelte Medienrückgewinnung vorgeschlagen, insbesondere eine Prozessgas- und/oder Inertgasrückgewinnung.

### FIGURENBESCHREIBUNG

Im Folgenden wird die Erfindung anhand der in den Figuren 1 bis 8 dargestellten Ausführungsbeispiele näher beschrieben und erläutert.
Fig. 1 zeigt Stand der Technik Wärmerückgewinnung aus der Abluft
Fig.2 zeigt Prozessgasreinigung / -rückführung
Fig.3 zeigt erfindungsgemäße Prozessgasreinigung mit Wärmerückgewinnung
Fig.4 zeigt eine schematische Skizze eines Reflow-Lötofens mit unterschiedlichen Wärmezonen und Temperaturprofil
Fig.5 zeigt schematisch ein Wärmebild eines Reflowlötofens und dessen Hitze-Peakbereiche der Reflowlötanlage, insbesondere beim Wärmetauscher der N2-Vorwärmung zur Gehäusekühlung
Fig.6 zeigt schematisch ein Wärmebild eines Reflowlötofens und die hohe Wärmeabgabe an die Umgebung im Übergangsbereich zwischen Deckel und Grundkörper der Reflowlötanlage
Fig.7 zeigt schematisch Wärmetauscher / N2-Vorwärmung zur Gehäusekühlung

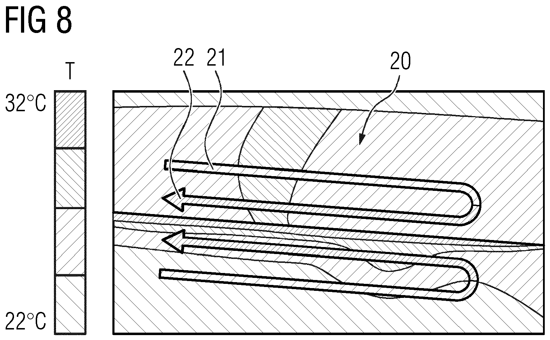

Fig.8 zeigt schematisch Zielgerichte Installation von Wärmetauschern oder Nutzung zur N2-Vorwärmung in Gehäusebereichen wo eine starke Wärmeabgabe an die Umgebung erfolgt In den Figuren 1 bis 3 ist in stark vereinfachter Darstellungsweise gezeigt, inwiefern eine Wärmerückgewinnung (Figur 1), eine Medienrückgewinnung (Figur 2) und eine kombinierte Wärme- und Medienrückgewinnung (Figur 3) für einen thermischen Prozessabschnitt einer Elektronikfertigung aussehen kann. In der Figur 1 ist dargestellt, wie aus einem thermischen Prozess 10 Wärme in Form von Abgas ausgeführt wird 21 und kühles Gas zugeführt wird 22, welches mittels eines beispielsweise doppelwandigen Wärmetauscherrohres 20 vorgewärmt den Prozessraum 10 erreicht. In Figur 2 ist eine Filtration oder Prozessgasreinigung 23 gezeigt, welche vom Prozessabgas 21 erreicht wird und aus welcher gereinigtes Prozessgas 22 in den thermischen Prozess 10 zurückgeführt wird. In Figur 3 ist die Kombination beider Verfahren gezeigt, bei welcher Kombination in einem doppelwandigen Wärmetauscherrohr eine gleichzeitige Prozessgasrückführung 22 und auch Wärmerückführung erfolgt.

In den Figuren 1 bis 3 wird grundlegend verdeutlicht, wie zentral die Bedeutung eines Kondensatmanagements ist, einer Wärmerückgewinnung aus den abgesaugten Prozessgasen. Dies kann analog der Brennwerttechnik bei Gasheizungen für Gebäude erfolgen, indem für die Zu- und Abführung der Prozessgase doppelwandige Rohre verwendet werden, d.h. in der Mitte wird das heiße Gas abgesaugt, in der äußeren Wandung das neue Prozessgas angesaugt und auf dem Weg zum Prozessraum vorgewärmt. Auch Plattenwärmetauscher, bei denen die Gase in mehreren Schichten aneinander vorbeiströmen, sind für diesen Zweck denkbar. Besonders effektiv ist dieses Verfahren, wenn zum Runterkühlen von Anlagen eine Schnellabsaugung genutzt wird, insbesondere mit maximaler Absaugleistung und Lüfterfrequenz, um das heiße Gas schnellstmöglich aus dem Prozessraum abzusaugen, wobei zeitgleich kaltes Gas z.B. Stickstoff N₂ zugeführt wird. Zudem werden Prozessgase, wie beispielsweise Stickstoff N₂, in geschlossenen Kreisläufen effektiver genutzt, indem die Gase über eine geeignete Filter- und Reinigungseinheit geschleust werden. Damit reduziert sich das notwendige Gasvolumen, welches von außen zugeführt werden muss. Diese geschlossenen Kreisläufe können energetisch durch die erfindungsgemäße Idee der Wärmerückgewinnung optimiert werden.

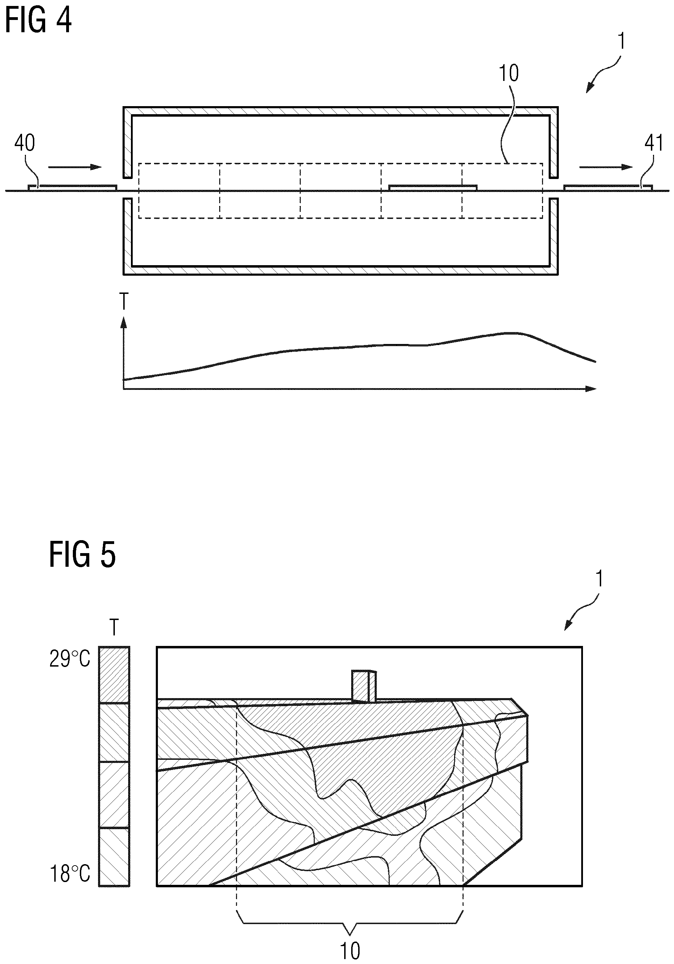

Figur 4 zeigt schematisch einen Querschnitt durch einen Ofen, dessen Zu- und Abfuhrbereich, über den bestückte Leiterplatten 40 noch ungelötet in den Ofen eingebracht werden und als fertig gelötete Leiterplatte 41 den Ofen verlassen. Innerhalb dieses Ofens 1 wird beispielsweise ein Reflow-Lötverfahren angewandt. Gezeigt sind verschiedene Temperaturzonen. Im Bereich der Hochtemperaturzone 10 ist ein Temperaturpeak zu verzeichnen, in welchem baulichen Bereich auch eine erhöhte Wärmeabgabe an die Umgebung erfolgt.

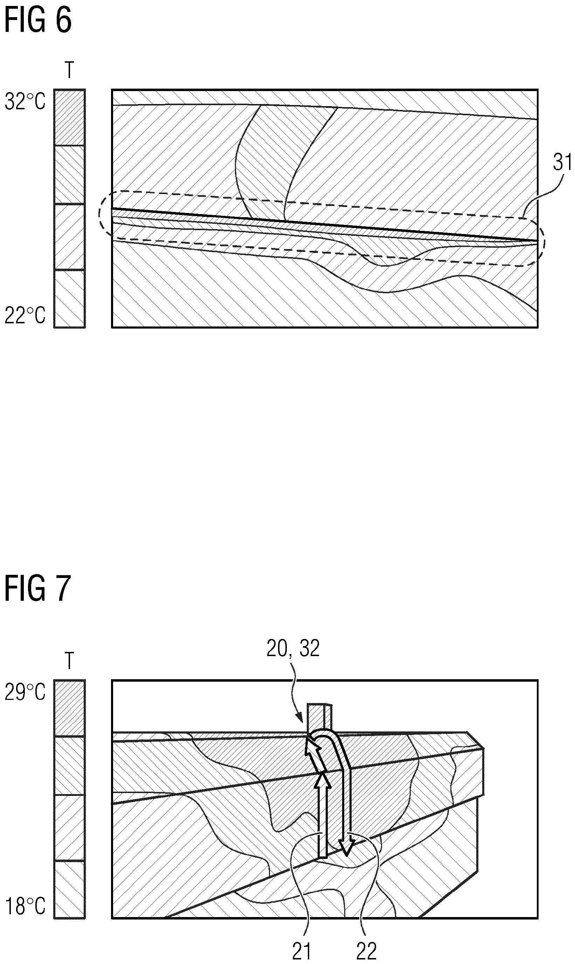

In den Figuren 5 und 6 sind Temperaturprofile skizziert, welche die Wärme-Peak-Zone 10 im Bereich des Deckels des Ofens und einen von Wärmeverlust geprägten Bereich des Übergangs 31 von Deckel zu Grundkörper des Ofens zeigen. Dabei liegen die Temperaturen in diesen Verlustbereichen bei ca. 25 bis 30°C.

In den Figuren 5 bis 6 wird ein weiterer Ansatz der effektiveren Energienutzung gezeigt. Die Vorwärmung des kalt zugeführten Gases über direkten Kontakt mit heißen Gehäuseteilen erfolgt insbesondere direkt an der Heizkammer, wie sie bei Reflowlötanlagen, Trocknungsöfen und Lötbädern der Wellenlötanlagen vorhanden ist, und führt zu Energieeinsparungen.

In den Figuren 7 und 8 ist gezeigt, wo beispielsweise Wärmerückgewinnungseinheiten, wie Wärmetauscherplatten oder Wärmetauscherrohre 20 angebracht werden können. In den gezeigten Beispielen in den Figuren 7 und 8 handelt es sich zunächst um besonders bevorzugte Bereiche für eine Wärmerückgewinnung aus heißen Gehäuseteilen. Gleichzeitig kann die Beströmung der Wärmetauscher 20 mit Prozessgas, insbesondere nach Reinigung und Filtration abgekühltem Prozessgas erfolgen, sodass dieses vorgewärmt in den Prozess zurückgeführt werden kann. In der Figur 7 ist noch vereinfacht angedeutet die geometrische Anpassung der Wärmetauscher an das Gehäuse. Wärmetauscherrohre sowie Plattenwärmetauscher können an eine Gehäusegeometrie angepasst sein.

Der Einsatz der beschriebenen Vorrichtung und des beschriebenen Verfahrens ist besonders vorteilhaft in Reflow-Lötanlagen einsetzbar, da die hier vorherrschenden Abwärmetemperaturen und Prozessgasbedingungen für einen Kreislauf gut geeignet sind. In Reflow-Lötanlagen wird bevorzugt mit Stickstoff (N2) als Prozessgas bzw. Inertgas gearbeitet.

Eine Wärmerückgewinnung aus der Abluft bzw. von heißen Gehäuseteilen thermischer Prozesse wird in der Elektronikindustrie heute noch nicht praktiziert. Über die hier beschriebenen Anwendungsbeispiele hinaus gibt es in elektronischen und mikroelektronischen Fertigungen weitere Anwendungsgebiete der vorgeschlagenen Wärmetauscher-Technologie, z.B. in CVD-Hochtemperatur-Öfen und allen thermischen Prozessen.

In den Ausführungsbeispielen und Figuren können gleiche oder gleich wirkende Elemente jeweils mit den gleichen Bezugszeichen versehen sein. Die dargestellten Elemente und deren Grö-βenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

### Bezugszeichenliste:

1 elektronische Fertigungsanlage, z.B. Reflow-Lötanlage
10 Thermischer Prozess, Heißzone, Peakbereich einer Reflow-Lötanlage
20 Wärmetauscher (insbesondere inkl. Prozessgaskreislauf)
21 Absaugung, insbesondere Absaugung der heißen Abluft in der Mitte eines doppelwandigen Rohres
22 Zuführung, insbesondere Zuführung des kalten Prozessgases über die äußere Wandung eines Rohres
23 Filter/Prozessgasreinigung
40 bestückte, ungelötete Leiterplatte
41 fertig gelötete Leiterplatte
T Temperatur
31 Übergang zwischen Deckel und Grundkörper einer Reflow-Lötanlage
32 Geometrisch angepasster Wärmetauscher an Gehäuse

## Patentansprüche

1. Verfahren zur Energieeinsparung in elektronischen Fertigungsprozessen, insbesondere mikroelektronischen Fertigungsprozessen, umfassend eine Wärmerückgewinnung und/oder eine Medienrückgewinnung.

2. Verfahren nach Anspruch 1 umfassend eine Wärmerückgewinnung gekoppelt mit einer Medienrückgewinnung.

3. Verfahren nach Anspruch 1 oder 2, wobei ein Fertigungsprozess zumindest einen thermischen Prozess umfasst, dessen Abwärme mittels eines Wärmetauschprozesses zumindest teilweise rückführbar ist.

4. Verfahren nach Anspruch 3, wobei der thermische Prozess ein Hochtemperatur-Prozess ist.

5. Verfahren nach Anspruch 3 oder 4, wobei der thermische Prozess Teil eines chemischen Gasphasenabscheideprozesses (CVD) ist.

6. Verfahren nach einem der vorstehenden Ansprüche, wobei zumindest ein Teil der Wärmerückgewinnung mittels eines Wärmetauschprozesses aus heißem Prozessabgas erfolgt.

7. Verfahren nach einem der vorstehenden Ansprüche, wobei zumindest ein Teil der Wärmerückgewinnung mittels eines Wärmetauschprozesses aus heißen Gehäuseteilen erfolgt.

8. Verfahren nach einem der vorstehenden Ansprüche, wobei zumindest ein Teil der Wärmerückgewinnung mittels eines Wärmetauschprozesses erfolgt, welcher bei Temperaturen zwischen 20°C und 80°C, insbesondere zwischen 20°C und 60°C, beispielsweise zwischen 20°C und 40°C erfolgt.

9. Verfahren nach einem der vorstehenden Ansprüche, wobei die Medienrückgewinnung eine Prozessgasrückgewinnung umfasst.

10. Verfahren nach Anspruch 9, wobei die Prozessgasrückgewinnung eine Prozessgasreinigung und/oder Prozessgasfiltration umfasst.

11. Verfahren nach Anspruch 9 oder 10, wobei die Prozessgasrückgewinnung über ein Kondensatmanagement in einem geschlossenen Kreislauf erfolgt.

12. Vorrichtung zur Energieeinsparung in elektronischen Fertigungsanlagen, insbesondere mikroelektronischen Fertigungsanlagen, umfassend wenigstens eine Wärmerückgewinnungseinheit und/oder wenigstens eine Medienrückgewinnungseinheit.

13. Vorrichtung nach Anspruch 12, umfassend eine Wärmerückgewinnungseinheit gekoppelt mit einer Medienrückgewinnungseinheit.

14. Vorrichtung nach einem der Ansprüche 12 oder 13, wobei die Wärmerückgewinnungseinheit einen Wärmetauscher, insbesondere ein Wärmetauscherrohr und/oder einen Plattenwärmetauscher umfasst.

15. Vorrichtung nach einem der Ansprüche 12 bis 14, wobei die Wärmerückgewinnungseinheit eine Schnellabsaugung umfasst.
